# FASCICULE DE BREVET EUROPEEN

(11) **EP 0 614 991 B1**
(45) Date de publication et mention de la délivrance du brevet: **28.04.1999**
(21) Numéro de dépôt: 94400414.2
(22) Date de dépôt: 28.02.1994
(51) Int. Cl.: C21D 1/76, C01B 33/04, C01B 6/06, C01B 6/10, C01B 25/06

(54) **Une solution diluée d'un hydrure dans de l'azote liquide**
Eine verdünnte Lösung eines Hydrids in Flüssig-Stickstoff
A diluted solution of a hydride in liquid nitrogen

(30) Priorité: 10.03.1993 FR 9302760
(43) Date de publication de la demande: 14.09.1994
(73) Titulaire: L'AIR LIQUIDE, SOCIETE ANONYME POUR L'ETUDE ET L'EXPLOITATION DES PROCEDES GEORGES CLAUDE, 75321 Paris Cédex 07 (FR)
(72) Inventeur: Karinthi, Pierre, F-78350 Jouy en Josas (FR); Jamonet, Bernard, F-26100 Bourge de Peage (FR)
(74) Mandataire: Vesin, Jacques

(56) Documents cités:
- EP-A- 0 247 555
- FR-A- 1 530 150
- FR-A- 2 278 385
- FR-A- 2 653 448
- FR-A- 2 668 166
- GB-A- 770 906
- J.FALBE ET AL. 'Römpp Chemie Lexikon' , GEORG THIEME VERLAG , STUTTGART -- NEW YORK 9ème édition * page 4152 - page 4153 *
- HOLLEMANN-WIBERG 'Lehrbuch der anorganischen Chemie' , WALTER DE GRUYTER & CO , BERLIN * page 44 *
- CHEMIE. INGENIEUR. TECHNIK, vol.60, no.11, 1988, WEINHEIM DE pages 815 - 821 H.-J. KLOCKNER ET AL.

## Description

Le document FR-A-1,530,150 évoque l'utilisation, à des fins métallurgiques, d'azote liquide ou encore d'argon liquide, dans lequel a été dissous de l'hydrogène, ou du monoxyde de carbone, ou encore des hydrocarbures à bas point d'ébullition.

On notera également que le document FR-A-2,278,385 évoque l'utilisation, pour la fabrication d'atmosphères de cémentation ou carbonitruration d'aciers, d'azote liquide ou d'argon liquide, dans lequel on a dissous des hydrocarbures gazeux, l'atmosphère gazeuse recherchée résultant de la vaporisation du mélange liquide ainsi formé.

L'invention concerne une solution d'un hydrure gazeux dans l'azote liquide, ledit hydrure étant choisi dans le groupe constitué par l'arsine, le germane, la phosphine, le diborane, le monosilane et le disilane, la concentration en ledit hydrure dans l'azote liquid étant comprise entre 0.05% et 10% molaire.

Les mélanges gazeux d'azote et d'hydrure tels le silane (SiH₄) sont utilisés dans de nombreux domaines d'application. Des mélanges d'azote et d'hydrure tel le silane sont notamment utilisés pour la fabrication de composants électroniques. Des mélanges gazeux d'azote et de silane gazeux peuvent aussi être utilisés pour la formation d'un dépôt à base d'oxyde de silicium (SiO_{X}, x étant inférieur ou égal à 2) sur la surface d'un support polymère ou un support métallique. Des procédés de traitement de surface de ce type ont notamment été décrits dans les demandes de brevet FR-A-2.670.506, FR-A-2.690.357 et FR-A-2 704 558, au nom de la Demanderesse.

Par ailleurs, FR-A-2.653.448 et FR-A-2.668.166, au nom de la Demanderesse, décrivent la réalisation d'atmosphères contrôlées, en particulier pour le traitement métallurgique, qui sont sensiblement exemptes de gaz oxydants ou de vapeurs oxydantes par injection de silane dans l'atmosphère où doit se dérouler ledit traitement.

A cette fin, la Demanderesse commercialise et conditionne en bouteilles, des mélanges gazeux sous pression constitués de silane et d'un gaz inerte (azote) dans lequel le silane est présent dans une proportion de 2 à 10 % en volume.

Ce conditionnement desdits mélanges à l'état gazeux présente les inconvénients suivants:
- les mélanges gazeux sous pression, prêts à l'emploi, occupent un volume important. De ce fait, le prix de leur transport est relativement élevé;
- les mélanges d'azote et d'un hydrure tel le silane, lorsque la teneur en ce dernier est supérieure à 2 %, sont spontanément inflammables à l'air et posent donc des problèmes de sécurité importants.

Il serait donc intéressant de disposer d'une source d'hydrures tels ceux mentionnés ci-dessus, plus commode d'emploi et moins dangereux.

L'invention vise à fournir une telle source obviant aux inconvénients mentionnés plus haut.

Les hydrures constitutifs d'une solution selon l'invention peuvent être choisis dans le groupe constitué par l'arsine, le germane, la phosphine (PH₃), le diborane, le disilane ou le silane (SiH₄).

La teneur en ledit hydrure dans la solution selon l'invention peut être comprise entre 0,05 et 10 % molaire, de préférence comprise entre 0,5 et 2 % molaire et plus préférentiellement, comprise entre 0,1 et 0,3 % molaire. Lorsque l'hydrure consiste en le silane, la teneur de celui-ci dans la solution peut avantageusement être voisine de 0,2 % molaire, par rapport au total de silane et d'azote liquide.

Dans le cas de la présente invention, un hydrure particulièrement préféré consiste en le silane (SiH₄). Le silane à l'état gazeux s'enflamme spontanément lorsque sa teneur dans l'air est supérieure à 2 % molaire. Une solution selon l'invention convient donc tout à fait pour le transport et pour augmenter la sécurité d'un tel hydrure.

Selon un autre aspect de l'invention, celle-ci concerne également une solution telle que définie ci-dessus, conditionnée dans un récipient tel un conteneur, une bouteille ou un réservoir du genre utilisé pour le conditionnement de l'azote liquide.

Dans un tel récipient, la solution en phase liquide est surmontée d'une phase gazeuse qui est principalement constituée d'azote contenant quelques parties d'hydrure par million. Cette phase gazeuse ne pose pas de problèmes de sécurité particuliers ni de stabilité en composition, si l'on prend soin d'extraire dudit récipient seulement la phase liquide. Si l'on prélève de la phase gazeuse, on élève progressivement la teneur en silane de la phase liquide.

Il est également possible, par une extraction simultanée, en proportions réglées, de la phase liquide et de la phase gazeuse, d'ajuster la composition du mélange gazeux extrait à une valeur désirée comprise entre les teneurs en hydrure de la phase liquide et de la phase gazeuse. Un dispositif comprenant un mélangeur et un système de vanne commandés, par exemple par un processeur du type de ceux couramment utilisés dans l'industrie, peuvent être utilisés à cette fin.

Une solution selon l'invention peut être préparée par simple mélange de ses constituants. Ainsi, on peut procéder au mélange de l'azote et de l'hydrure, ces deux corps étant à l'état liquide. Plus avantageusement, on peut procéder à la préparation d'une solution selon l'invention en faisant barboter dans de l'azote liquide l'hydrure à l'état gazeux. Cet hydrure à l'état gazeux peut être utilisé pur ou en mélange avec de l'azote.

Une solution selon l'invention, selon la nature de l'hydrure qu'elle contient, peut être notamment utilisée pour la fabrication de composants électroniques, notamment en épitaxie, pour le dopage ou pour la gravure de tels composants. Une telle solution peut également être utilisée pour la préparation d'atmosphères. d'inertage ou de traitement thermique, notamment d'atmosphères de traitement thermique de métaux. Pour ce type d'applications, l'hydrure consiste essentiellement en le silane. Enfin une solution selon l'invention peut encore être utilisée pour le traitement de surfaces, notamment de surfaces en un polymère ou métalliques, par exemple selon les procédés décrits dans les demandes de brevet français mentionnées ci-dessus : FR-A-2.670.506, FR-A-2.690.357 et FR-A-2 704 558, dont référence est intégrée dans la présente demande de brevet.

Dans ce type de procédé, l'hydrure constitutif de la solution selon l'invention consiste essentiellement en le silane. Ces procédés ont pour but de conférer aux surfaces traitées des propriétés chimiques ou physiques modifiées. Ils ont notamment pour but d'améliorer la mouillabilité d'une surface en un polymère tel le polyéthylène ou le polypropylène.

Une solution selon l'invention peut être utilisée pour préparer un mélange gazeux qui va être utilisé tel quel dans l'une des applications mentionnées ci-dessus. Alternativement, le mélange gazeux obtenu à partir de ladite solution peut être dilué par de l'azote gazeux en vue d'obtenir des concentrations réduites en hydrure. Cette dilution par de l'azote gazeux peut être telle que le mélange gazeux constitué de l'hydrure et de l'azote comporte par exemple de 40 à 200 parties par million en ledit hydrure.

Les exemples qui suivent ont pour but d'illustrer la présente invention.

### Exemple 1

On introduit 18,5 kg de silane (SiH₄) sous forme pure dans un réservoir contenant 10 000 litres d'azote liquide pour obtenir un mélange à 0,2 % molaire de silane.

La phase gazeuse en équilibre avec le mélange contient quelques parties par million de silane. En raison de cette faible teneur en silane, la phase gazeuse ne pose aucun problème de sécurité.

### Exemple 2

Dans un récipient contenant 26,7 kg d'azote liquide, on fait barboter un mélange gazeux d'azote et de silane. La concentration en silane dans ce mélange gazeux est de 1,85 % molaire. Le débit du mélange gazeux est de 30 normo-litres/minute. On fait barboter le mélange gazeux jusqu'à l'obtention d'une solution liquide contenant 0,63 % molaire de silane pour une masse totale de mélange de 19 kg.

## Revendications

1. Une solution d'un hydrure gazeux dans de l'azote liquide, ledit hydrure étant choisi dans le groupe constitué par l'arsine, le germane, la phosphine, le diborane, le monosilane et le disilane, la concentration en ledit hydrure dans l'azote liquide étant comprise entre 0,05 % et 10 % molaire.

2. Solution selon la revendication 1, caractérisée en ce que la concentration en ledit hydrure dans l'azote liquide est comprise entre 0,05 % et 2 % molaire, de préférence entre 0,1 % et 0,3 % molaire.

3. Solution selon l'une des revendications 1 ou 2, caractérisée en ce qu'elle est conditionnée dans un récipient tel un conteneur, un réservoir ou une bouteille, du type utilisé pour stocker l'azote liquide.

4. Solution selon l'une des revendications 1 à 3, caractérisée en ce que l'hydrure est le monosilane (SiH₄).

5. Utilisation dune solution telle que revendiquée selon l'une des revendications 1 à 4, pour la préparation atmosphères de traitement thermique, notamment le traitement thermique des métaux.

6. Utilisation dune solution telle que revendiquée selon l'une des revendications 1 4, pour la préparation d'une atmosphère dinertage.

7. Utilisation d'une solution telle que revendiquée selon l'une des revendications 1 à 4, pour la préparation d'une atmosphère destinée au traitement de surface, notamment de surfaces polymères ou métalliques.

## Patentansprüche

1. Lösung eines gasförmigen Hydrids in Flüssigstickstoff, wobei das Hydrid aus der aus Arsin, German, Phosphin, Diboran, Monosilan und Disilan gebildeten Gruppe ausgewählt ist und die Konzentration des Hydrids in dem Flüssigstickstoff zwischen 0,05 Mol-% und 10 Mol-% liegt.

2. Lösung nach Anspruch 1, dadurch gekennzeichnet, daß die Konzentration des Hydrids in dem Flüssigstickstoff zwischen 0,05 Mol-% und 2 Mol-%, bevorzugt zwischen 0,1 Mol-% und 0,3 Mol-%, liegt.

3. Lösung nach einem der Ansprüche 1 oder 2, dadurch gekennzeichnet, daß sie in einem Behältnis wie einem Container, einem Tank oder einer Flasche der zur Lagerung von Flüssigstickstoff verwendeten Art abgefüllt ist.

4. Lösung nach einem der Ansprüche 1 bis 3, dadurch gekennzeichnet, daß das Hydrid Monosilan (SiH₄) ist.

5. Verwendung einer nach einem der Ansprüche 1 bis 4 beanspruchten Lösung zur Herstellung von Atmosphären für die thermische Behandlung, insbesondere für die thermische Behandlung von Metallen.

6. Verwendung einer nach einem der Ansprüche 1 bis 4 beanspruchten Lösung zur Herstellung einer Inertisierungs-Atmosphäre.

7. Verwendung einer nach einem der Ansprüche 1 bis 4 beanspruchten Lösung zur Herstellung einer für die Behandlung von Oberflächen, insbesondere von Polymer- oder Metalloberflächen bestimmten Atmosphäre.

## Claims

1. Solution of a gaseous hydride in liquid nitrogen, the said hydride being chosen from the group consisting of arsine, germane, phosphine, diborane, monosilane and disilane, the concentration of the said hydride in the liquid nitrogen being between 0.05 mol% and 10 mol%.

2. Solution according to Claim 1, characterized in that the concentration of the said hydride in the liquid nitrogen is between 0.05 mol% and 2 mol%, preferably between 0.1 mol% and 0.3 mol%.

3. Solution according to either of Claims 1 and 2, characterized in that it is packaged in a vessel such as a container, a tank or a bottle, of the type used to store liquid nitrogen.

4. Solution according to one of Claims 1 to 3, characterized in that the hydride is monosilane (SiH₄).

5. Use of a solution as claimed according to one of Claims 1 to 4, for the preparation of heat-treatment atmospheres, in particular for the heat-treatment of metals.

6. Use of a solution as claimed according to one of Claims 1 to 4, for the preparation of an inertization atmosphere.

7. Use of a solution as claimed according to one of Claims 1 to 4, for the preparation of an atmosphere intended for surface treatment, in particular of polymer or metal surfaces.
